# EUROPÄISCHE PATENTSCHRIFT

(11) **EP 1 497 862 B1**
(45) Veröffentlichungstag und Bekanntmachung des Hinweises auf die Patenterteilung: **20.12.2006**
(21) Anmeldenummer: 03746805.5
(22) Anmeldetag: 09.04.2003
(51) Int. Cl.: H01L 23/522, H01L 27/08

(54) **HALBLEITERBAUELEMENT MIT INTEGRIERTER GITTERFÖRMIGER KAPAZITÄTSSTRUKTUR**
SEMICONDUCTOR COMPONENT COMPRISING AN INTEGRATED LATTICED CAPACITANCE STRUCTURE
COMPOSANT A SEMI-CONDUCTEURS COMPORTANT UNE STRUCTURE CAPACITIVE INTEGREE EN FORME DE GRILLE

(30) Priorität: 19.04.2002 DE 10217565
(43) Veröffentlichungstag der Anmeldung: 19.01.2005
(73) Patentinhaber: Infineon Technologies AG, 81669 München (DE)
(72) Erfinder: DA DALT, Nicola, A-9500 Villach (AT)
(74) Vertreter: Graf Lambsdorff, Matthias
(86) Internationale Anmeldenummer: PCT/DE2003/001171
(87) Internationale Veröffentlichungsnummer: WO 2003/090279

(56) Entgegenhaltungen:
- WO-A-01/75983
- WO-A-01/91144
- DE-A- 10 046 910
- DE-A1- 10 019 839
- DE-C- 19 850 915
- US-A- 5 208 725
- US-A- 5 583 359
- US-A- 6 037 621
- APARICIO R ET AL: "Capacity limits and matching properties of integrated capacitors" PROCEEDINGS OF THE IEEE 2001 CUSTOM INTEGRATED CIRCUITS CONFERENCE, SAN DIEGO, CA, USA, 6-9 MAY 2001, Bd. 37, Nr. 3, Seiten 384-393, XP002252607 IEEE Journal of Solid-State Circuits, March 2002, IEEE, USA ISSN: 0018-9200

## Beschreibung

Die vorliegende Erfindung betrifft ein Halbleiterbauelement mit einem Halbleitersubstrat auf dem eine Isolationsschicht ausgebildet ist, wobei in der Isolationsschicht eine Kapazitätsstruktur ausgebildet ist.

In den meisten analogen Schaltungsteilen gemischt digitalanaloger Schaltungen werden Kondensatoren mit hohem Kapazitätswert, großer Linearität und hoher Güte benötigt. Um die Kosten der Herstellung des Bauelements möglichst gering zu halten, ist es erforderlich, dass die Herstellung der Kapazitätsstrukturen möglichst wenig Prozessschritte erfordern. Des Weiteren ist mit der fortschreitenden Miniaturisierung der Bauelemente und integrierten Schaltungen auch die Forderung nach möglichst wenig Flächenbedarf für die Kapazitätsstruktur einhergehend.

Eine im Stand der Technik bekannte Kapazitätsstruktur ist aus der Patentschrift DE 198 50 915 C1 bekannt. Eine als sogenannte Sandwich-Kapazität ausgebildete Struktur weist zwei auf einem Halbleitersubstrat aufgebrachte und durch eine dielektrische Schicht voneinander getrennte leitende Beläge auf. Der auf der dielektrischen Schicht aufliegende obere Belag ist über mindestens eine leitende Luftbrücke mit mindestens einem von zwei Anschlussleitern der Kapazität verbunden. Parasitäre Induktivitäten der Kapazität werden weitgehend dadurch kompensiert, dass die beiden Anschlussleiter durch mindestens eine, die Kapazität überbrückende, hochohmige Leitung miteinander verbunden sind.

Eine weitere Ausbildung einer Kapazitätsstruktur ist aus der Patentschrift US 5,208,725 bekannt. Auf einem Halbleitersubstrat wird eine Mehrzahl erster streifenförmig ausgebildeter Leitungen parallel zueinander angeordnet. Durch eine dielektrische Schicht getrennt, wird deckungsgleich auf diese ersten Leitungen eine Mehrzahl an zweiten Leitungen angeordnet. Indem vertikal und lateral benachbarte Leitungen auf verschiedenem Potenzial liegen, werden sowohl Kapazitäten zwischen übereinander liegenden Leitungen als auch Kapazitäten zwischen benachbarten Leitungen in einer Ebene erzeugt. Ein wesentlicher Nachteil dieser Struktur liegt darin, dass bei minimaler Verschiebung der übereinander angeordneten Metallleitungen die vertikalen Kapazitätsanteile relativ stark vermindert werden und der Anteil der Nutzkapazität reduziert wird.

Eine weitere Kapazitätsstruktur ist in Aparicio, R. und Hajimiri, A.: Capacitiy Limits and Matching Properties of Lateral Flux Integrated Capacitors; IEEE Custom Integrated Circuits Conference, San Diego May 6 - 9, 2001, offenbart. Senkrecht angeordnete Stabstrukturen werden symmetrisch zueinander angeordnet. Jeder der Stäbe wird aus Metallbereichen und Via-Bereichen, die abwechselnd aufeinander angeordnet sind aufgebaut. Die Metallflecken eines Stabes sind auf ein gemeinsames Potenzial gelegt. Metallflecken benachbarter Stäbe weisen unterschiedliches Potenzial auf. Die Via-Bereiche kontaktieren jeweils zwei benachbarte Metallbereiche eines Stabes. Die Herstellung dieser Struktur ist sehr aufwändig - viele Maskenschritte sind notwendig - und die Kapazitätsdichte ist durch die minimale Größe der Metallbereiche in den Stäben begrenzt. Die Größe dieser Metallbereiche ist jedoch deutlich größer als die Größe der Via-Bereiche in den Stäben, was daran liegt, dass an Masken für die Herstellung der Metallbereiche andere Anforderungen gestellt werden als an Masken mit denen die Via-Bereiche hergestellt werden. Nachteilig bei diesen Kapazitätsstrukturen ist, dass die parasitäre Kapazität zum Substrat relativ groß ist und unabhängig von der Orientierung der Kapazitätsstruktur - ursprüngliche Orientierung bzw. vertikale Drehung um 180° - zum Substrat im wesentlichen gleich groß ist.

Aus der Patentschrift US 5,583,359 ist eine Kapazitätsstruktur für einen integrierten Schaltkreis bekannt. Dort wird eine Mehrzahl an Metallplatten, welche die Elektroden eines Stapelkondensators bilden, durch dielektrische Schichten getrennt, übereinander angeordnet. Jede Metallplatte weist an einem Randbereich eine Aussparung auf, in der in der Ebene der Metallplatte eine von der jeweiligen Platte isolierte Metalleitung in Form eines Streifens angeordnet ist. Die Metalleitungen sind jeweils von beiden Seiten mit Via-Verbindungen kontaktiert, wodurch zum einen alle ungeradzahlig und zum anderen alle geradzahlig in dem Stapel positionierten Platten elektrisch miteinander verbunden werden. Indem die geradzahlig positionierten Platten an eine erste Anschlussleitung und die ungeradzahlig positionierten Platten an eine zweite Anschlussleitung angelegt werden, weisen benachbarte Platten unterschiedliches Potenzial auf und bilden jeweils paarweise Elektroden eines Plattenkondensators. Die Kapazitätsoberfläche wird somit im wesentlichen durch die Plattenoberflächen gebildet. Bei einer alternativen Ausbildung ist eine der Elektroden des Stapelkondensators als homogene Metallplatte ausgebildet, die von einem Rahmen umgeben ist, der beabstandet zur Metallplatte angeordnet ist und auf einem zur Metallplatte unterschiedlichen Potenzial liegt. Eine ähnliche Kapazitätsstruktur ist in der Patentschrift DE 100 19 839 beschrieben, wobei dort die Via-Verbindungen durch Löcher in den Metallplatten hindurch geführt sind. Die dargestellten Kapazitätsstrukturen weisen unabhängig von ihrer Anordnung zum Substrat eine relativ hohe parasitäre Kapazität auf. In einer Reihe neuartiger Applikationen in denen Kapazitätsstrukturen benötigt werden, ist es erwünscht bzw. notwendig, Kapazitätsstrukturen auszubilden, bei denen zumindest eine Elektrodenstruktur der Kapazität im Vergleich zu der zweiten Elektrodenstruktur eine relativ geringe, bestenfalls keine, parasitäre Kapazität in Bezug zum Substrat aufweist.

Es ist daher Aufgabe der vorliegenden Erfindung, ein Halbleiterbauelement mit einer integrierten Kapazitätsstruktur zu schaffen, bei dem das Verhältnis von Nutzkapazität zu parasitärer Kapazität verbessert werden kann.

Diese Aufgabe wird durch ein Halbleiterbauelement, welches die Merkmale des Patentanspruchs 1 aufweist, gelöst.

Ein Halbleiterbauelement weist ein Halbleitersubstrat auf, auf dem ein Schichtensystem aus einer oder mehreren Isolationsschichten und dielektrischen Schichten angeordnet ist. In dieser Isolationsschicht oder in diesem IsolationsschichtenSystem ist eine Kapazitätsstruktur ausgebildet.

Die Kapazitätsstruktur weist eine erste Teilstruktur auf, die im wesentlichen vollständig in einer ersten Ebene ausgebildet ist und zwei Elemente aufweist. Ein erstes Element der Teilstruktur ist als gitterförmiger Bereich ausgebildet, welcher mehrere zusammenhängende, metallische Rahmenstrukturen aufweist. Der gitterförmige Bereich erstreckt sich im wesentlichen parallel zur Substratoberfläche und kann insbesondere in einer Metallisierungsebene ausgebildet sein. Der gitterförmige Bereich ist mit einer ersten Anschlussleitung elektrisch verbunden. Erfindungsgemäß weist die erste Teilstruktur elektrisch leitende, in den Aussparungen des gitterförmigen Bereichs angeordnete Bereiche auf, die metallische Platten oder Knotenpunkte zwischen Via-Verbindungen sind. Jeder elektrisch leitende Bereich ist in einer der Aussparungen beabstandet zu den Randbereichen dieser Aussparung angeordnet. Die elektrisch leitenden Bereiche sind mit einer zweiten Anschlussleitung elektrisch verbunden.

Dadurch wird eine Kapazitätsstruktur mit einer relativ kleinen parasitären Kapazität ermöglicht, die darüber hinaus relativ einfach herzustellen ist - wenige Maskenschritte - und wenig Platz benötigt. Dadurch können auch kleinste Kapazitätsstrukturen mit relativ hoher Nutzkapazität und verbessertem Verhältnis von Nutzkapazität zu parasitärer Kapazität realisiert werden.

In einer vorteilhaften Ausgestaltung sind die elektrisch leitenden Bereiche als metallische Platten oder als elektrisch leitende Knotenpunkte ausgebildet, wobei jeder Knotenpunkt als ein Ende einer Via-Verbindung oder aber eine Verbindung durch die jeweils zwei Via-Verbindungen verbunden sind, ausgebildet sein kann. Die Via-Verbindungen können als elektrische Verbindungen ausgebildet sein, die Teilstrukturen der Kapazitätsstruktur elektrisch verbinden oder eine Teilstruktur der Kapazitätsstruktur und einen nicht zur Kapazitätsstruktur gehörenden Bereich des Halbleiterbauelements elektrisch verbinden.

In einer bevorzugten Ausführung weist die Kapazitätsstruktur eine zweite Teilstruktur auf, die parallel und beabstandet zur ersten Teilstruktur in der Isolationsschicht ausgebildet ist und mit der ersten Teilstruktur elektrisch verbunden ist. Die zweite Teilstruktur weist einen metallischen, zusammenhängenden gitterförmigen Bereich auf.

Dadurch kann das Verhältnis von Nutzkapazität zu parasitärer Kapazität der Kapazitätsstruktur vergrößert werden, wobei eine Elektrodenstruktur im Vergleich zur zweiten Elektrodenstruktur eine minimale parasitäre Kapazität zum Substrat aufweist.

Ein vorteilhaftes Ausführungsbeispiel kennzeichnet sich dadurch, dass die zweite Teilstruktur im wesentlichen gleich der ersten Teilstruktur ausgebildet ist und die beiden Teilstrukturen so zueinander vertikal versetzt angeordnet sind, dass Kreuzungspunkte des gitterförmigen Bereichs der ersten Teilstruktur senkrecht über den elektrisch leitenden Bereichen der zweiten Teilstruktur und die elektrisch leitenden Bereiche der ersten Teilstruktur senkrecht über den Kreuzungspunkten des gitterförmigen Bereichs der zweiten Teilstruktur angeordnet sind.

Bevorzugt sind die zwei Teilstrukturen mittels Via-Verbindungen elektrisch verbunden. Es kann vorgesehen sein, dass jeder der senkrecht übereinander angeordneten Paare aus einem elektrisch leitenden Bereich und einem Kreuzungspunkt mittels einer oder mehreren Via-Verbindungen elektrisch verbunden sind. Abhängig von der durch die bei der Herstellung der Kapazitätsstruktur bzw. bei dem Halbleiterbauelement verwendeten Technologie, kann dadurch jeweils eine relativ gute und sichere elektrische Verbindung zwischen den einzelnen Ebenen bzw. den Teilstrukturen geschaffen werden.

Ein weiteres Ausführungsbeispiel kennzeichnet sich in vorteilhafter Weise dadurch, dass die zweite Teilstruktur lediglich einen metallischen gitterförmigen Bereich aufweist, der zur ersten Teilstruktur derart versetzt ist, dass die Kreuzungspunkte des gitterförmigen Bereichs der zweiten Teilstruktur senkrecht unter den elektrisch leitenden Bereichen der ersten Teilstruktur angeordnet sind. Die elektrische Verbindung zwischen der ersten und der zweiten Teilstruktur ist bevorzugt durch Via-Verbindungen erzeugt, wobei die elektrische Verbindung zwischen den elektrisch leitenden Bereichen der ersten Teilstruktur und den Kreuzungspunkten des gitterförmigen Bereichs ausgeführt sind. Diese Ausführungsform weist eine besonders niedrige parasitäre Kapazität auf. Insbesondere durch die dem Substrat näherliegende zweite Teilstruktur, welche nur als gitterförmige Struktur ausgebildet ist, wird eine Elektrodenstruktur erzeugt, die eine erheblich reduzierte parasitäre Kapazität zum Substrat im Vergleich zur anderen Elektrodenstruktur der gesamten Kapazitätsstruktur aufweist.

Ein weitere vorteilhafte Ausgestaltung ist durch eine dritte Teilstruktur der Kapazitätsstruktur gekennzeichnet. Die dritte Teilstruktur ist als metallische Platte ausgebildet und ist zwischen der Substratoberfläche und der zweiten Teilstruktur angeordnet. Die dritte Teilstruktur kann mittels Via-Verbindungen mit den elektrisch leitenden Bereichen oder mit den Kreuzungspunkten des gitterförmigen Bereichs der zweiten Teilstruktur elektrisch verbunden sein.

Weitere vorteilhafte Ausgestaltung des erfindungsgemäßen Halbleiterbauelements sind in den Unteransprüchen angegeben.

Nachfolgend werden mehrere Ausführungsbeispiele des erfindungsgemäßen Halbleiterbauelements anhand schematischer Zeichnungen näher erläutert. Es zeigen:
- Fig. 1: eine perspektivische Darstellung eines ersten Ausführungsbeispiels eines erfindungsgemäßen Halbleiterbauelements;
- Fig. 2: eine perspektivische Darstellung eines zweiten Ausführungsbeispiels des erfindungsgemäßen Halbleiterbauelements;
- Fig. 3: eine perspektivische Darstellung eines dritten Ausführungsbeispiels des erfindungsgemäßen Halbleiterbauelements;
- Fig. 4: eine perspektivische Darstellung eines vierten Ausführungsbeispiels des erfindungsgemäßen Halbleiterbauelements;
- Fig. 5: eine Draufsicht auf ein Halbleiterbauelement nach einer der Fig. 1 bis 3; und
- Fig. 6: eine Draufsicht auf eine weitere Ausführungsform des Halbleiterbauelements.

In den Figuren bezeichnen gleiche Bezugszeichen gleiche oder funktionsgleiche Elemente.

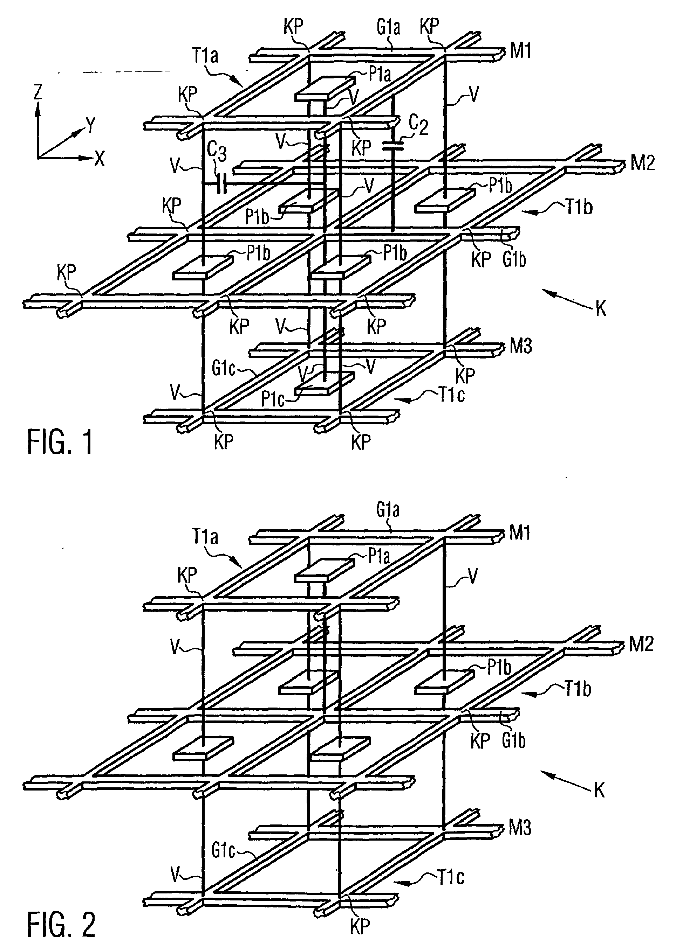

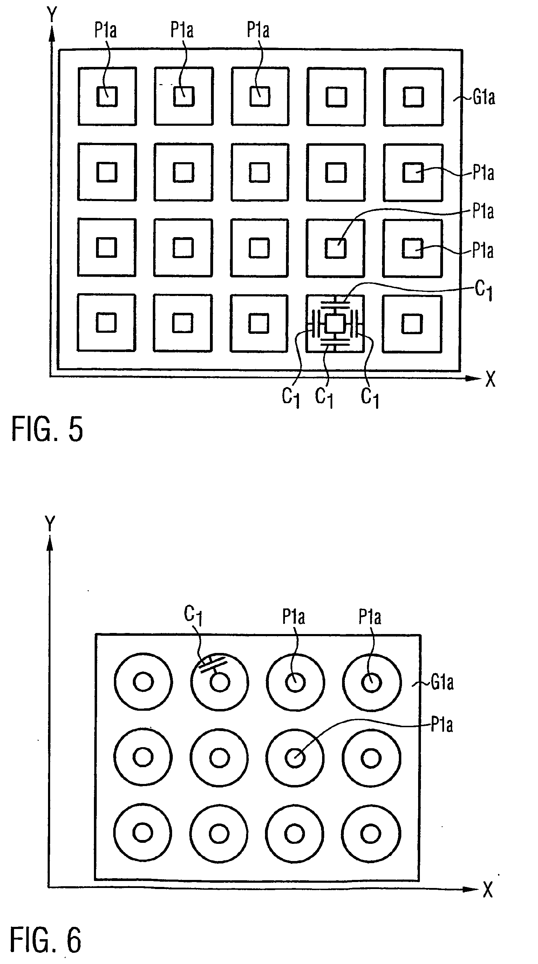

Ein erfindungsgemäßes Halbleiterbauelement (Fig. 1) weist eine Kapazitätsstruktur K auf, die in einer nicht dargestellten Isolationsschicht oder einem Isolationsschichtensystem ausgebildet ist. Die Isolationsschicht und die Kapazitätsstruktur K sind auf einem nicht dargestellten Halbleitersubstrat angeordnet. Die Kapazitätsstruktur K weist im Ausführungsbeispiel eine erste Teilstruktur T1a auf. Die Teilstruktur T1a ist aus einem metallischen gitterförmigen Bereich G1a und mehreren metallischen Platten P1a ausgebildet. In jeder der Aussparungen des gitterförmigen Bereichs G1a ist eine metallische Platte P1a zentrisch angeordnet. Die metallischen Platten P1a und der gitterförmige Bereich G1a sind in einer Metallisierungsebene M1 ausgebildet, wobei der gitterförmige Bereich G1a mit einer ersten nicht dargestellten Anschlussleitung elektrisch verbunden ist und eine Elektrode der Kapazitätsstruktur K bildet. Die metallischen Platten P1a sind mit einer nicht dargestellten zweiten Anschlussleitung elektrisch verbunden. Dadurch werden in der Metallisierungsebene M1 erste Nutzkapazitätsanteile der Kapazitätsstruktur gebildet. Diese Kapazitätsanteile C₁ (in Fig. 5 dargestellt) werden jeweils zwischen den sich in der Metallisierungsebene M1 gegenüberstehenden Oberflächenbereichen des gitterförmigen Bereichs G1a und einer metallischen Platte P1a gebildet.

Die Kapazitätsstruktur K weist eine zweite Teilstruktur T1b auf, die entsprechend der ersten Teilstruktur T1a ausgebildet ist. Die Teilstruktur T1b ist in einer zweiten Metallisierungsebene M2 ausgebildet, die parallel und beabstandet zur ersten Metallisierungsebene M1 ausgebildet ist, wobei die beiden Metallisierungsebenen durch die Isolationsschicht oder eine in dem Isolationsschichtensystem ausgebildete dielektrische Schicht voneinander getrennt sind. Die Teilstruktur T1b weist einen gitterförmigen Bereich G1b und metallische Platten P1b auf. Die zweite Teilstruktur T1b ist in der x-y-Ebene gegenüber der ersten Teilstruktur T1a versetzt angeordnet und zwar derart, dass die metallischen Platten P1b vertikal unter den Kreuzungspunkten KP des gitterförmigen Bereichs G1a der ersten Teilstruktur T1a angeordnet sind.

Jeder der Kreuzungspunkte KP des gitterförmigen Bereichs G1a ist mit der senkrecht darunter angeordneten metallischen Platte P1b und jede metallische Platte P1a mit dem senkrecht darunter angeordneten Kreuzungspunkt KP des gitterförmigen Bereichs G1b mittels Via-Verbindungen V elektrisch verbunden. Im Ausführungsbeispiel ist jede elektrische Verbindung zwischen einem Kreuzungspunkt KP und einer metallischen Platte mit einer einzigen Via-Verbindung V erzeugt. Es kann auch vorgesehen sein, das zwischen einem Kreuzungspunkt KP und einer metallischen Platte zwei oder mehrere Via-Verbindungen V ausgebildet sind.

Durch die elektrische Verbindung der ersten Teilstruktur T1a mit der zweiten Teilstruktur T1b durch die Via-Verbindungen V sind die metallischen Platten P1b mit der ersten Anschlussleitung und der gitterförmige Bereich G1b mit der zweiten Anschlussleitung elektrisch verbunden. Dadurch werden weitere Nutzkapazitätsanteile gebildet. Zum einen werden in der x-y-Ebene zwischen den sich gegenüberliegenden Oberflächenbereichen der metallischen Platten P1b und dem gitterförmigen Bereich G1b weitere Kapazitätsanteile C₁ erzeugt. Kapazitätsanteile C₂ werden zwischen den gitterförmigen Bereichen G1a und G1b an den Stellen gebildet, an denen sich Oberflächenbereiche der Gitterstrukturen in z-Richtung betrachtet - entspricht einer Draufsicht auf die Fig. 1 - schneiden. Beispielhaft und stellvertretend für alle anderen derartig erzeugten Kapazitätsanteile C₂ ist eine einzige in der Fig. 1 eingezeichnet. Weitere Kapazitätsanteile C₃, die zur Nutzkapazität der Kapazitätsstruktur K beitragen, werden zwischen den Via-Verbindungen V erzeugt. Dabei sind die Via-Verbindungen V, welche eine elektrische Verbindung zwischen den metallischen Platten P1a und den Kreuzungspunkten KP des gitterförmigen Bereichs G1b herstellen, mit der zweiten Anschlussleitung verbunden und weisen ein anderes Potenzial auf, als die Via-Verbindungen V, die eine elektrische Verbindung zwischen den Kreuzungspunkten KP des gitterförmigen Bereichs G1a und den metallischen Platten P1b herstellen. Beispielhaft und stellvertretend für alle anderen derartig erzeugten Kapazitätsanteile C₃ ist eine einzige in der Fig. 1 eingezeichnet.

Eine weitere Teilstruktur T1c der Kapazitätsstruktur K ist in der Metallisierungsebene M3 ausgebildet. Die Teilstruktur T1c ist ebenfalls entsprechend der ersten Teilstruktur T1a ausgebildet und weist einen metallischen gitterförmigen Bereich G1c auf, in dessen Aussparungen metallische Platten P1c angeordnet sind. Die Teilstruktur T1c ist im wesentlichen deckungsgleich zur Teilstruktur T1a angeordnet. Dadurch sind die Kreuzungspunkte KP des gitterförmigen Bereichs G1c der Teilstruktur T1c senkrecht unter den metallischen Platten P1b angeordnet und die metallischen Platten P1c senkrecht unter den Kreuzungspunkten KP des gitterförmigen Bereichs G1b der Teilstruktur T1b angeordnet. Durch Via-Verbindungen V werden die elektrischen Verbindungen jeweils zwischen den Kreuzungspunkten KP und den metallischen Platten P1b bzw. P1c erzeugt.

Dadurch ist der gitterförmige Bereich G1c mit der ersten Anschlussleitung und die metallischen Platten P1c mit der zweiten Anschlussleitung elektrisch verbunden.

Entsprechend den obigen Erläuterungen werden Kapazitätsanteile C₁ zwischen den metallischen Platten P1c und dem gitterförmigen Bereich G1c in der x-y-Ebene erzeugt. Kapazitätsanteile C₂ werden zwischen den Teilstrukturen T1b und T1c entsprechend denen zwischen den Teilstrukturen T1a und T1b ausgebildet. Ebenso werden die Kapazitätsanteile C₃ zwischen den auf unterschiedlichem Potenzial liegenden Via-Verbindungen V erzeugt.

Durch diese Struktur kann die parasitäre Kapazität zwischen der Kapazitätsstruktur K und dem Substrat wesentlich reduziert werden.

Ein weiteres Ausführungsbeispiel ist in Fig. 2 dargestellt. Die Kapazitätsstruktur K entspricht im wesentlichen derjenigen gemäß Fig. 1. Ein Unterschied besteht darin, dass die dritte Teilstruktur T1c lediglich aus dem gitterförmigen Bereich G1c aufgebaut ist. Dadurch entfallen zwar für die Nutzkapazität die Kapazitätsanteile C₁ in der Metallisierungsebene M3 sowie die Kapazitätsanteile zwischen den auf unterschiedlichem Potenzial liegenden Via-Verbindungen V zwischen der Teilstruktur T1b und der Teilstruktur T1c. Jedoch wird durch das Weglassen der metallischen Platten P1c die parasitäre Kapazität wesentlich verringert.

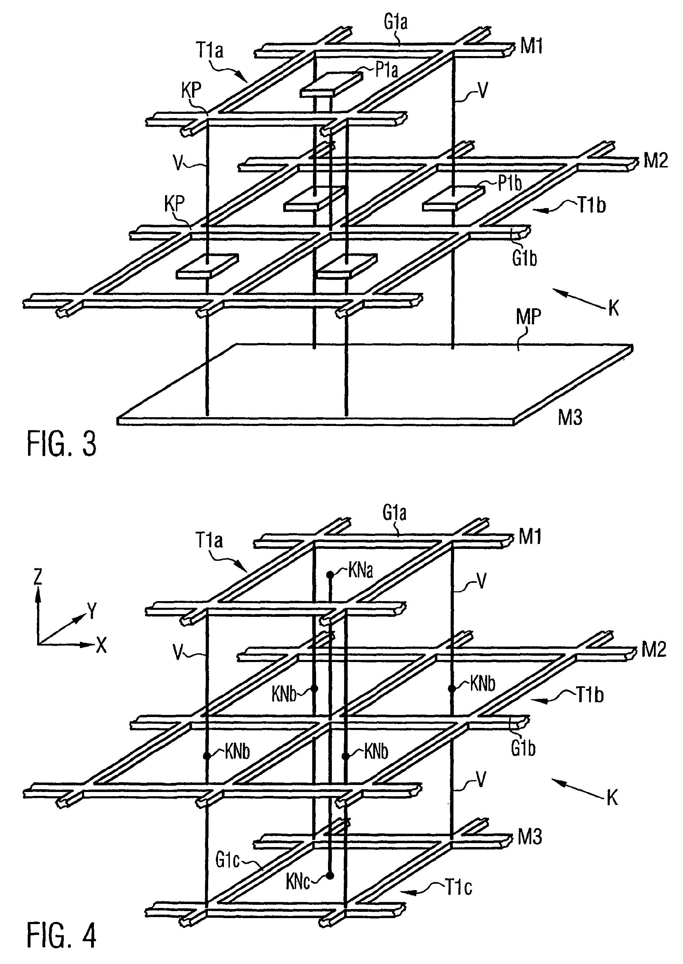

Ein weiteres Ausführungsbeispiel ist in Fig. 3 gezeigt. Die Kapazitätsstruktur K entspricht im wesentlichen derjenigen in Fig. 1. Ein Unterschied bei diesem Beispiel besteht darin, dass die Teilstruktur T1c als einstückige Metallplatte MP ausgebildet ist, die mittels Via-Verbindungen V mit den metallischen Platten P1b der Teilstruktur T1b verbunden ist und damit mit der ersten Anschlussleitung elektrisch verbunden ist.

Die weitere Kapazitätsstruktur K eines erfindungsgemäßen Halbleiterbauelements ist in Fig. 4 dargestellt. Diese Kapazitätsstruktur K entspricht derjenigen in Fig. 1. Die metallischen Platten P1a, P1b und P1c sind in diesem Ausführungsbeispiel durch elektrisch leitende Knotenpunkte KNa bis KNc ersetzt, die im Ausführungsbeispiel zwischen Via-Verbindungen V ausgebildet sind. Besteht die Kapazitätsstruktur K beispielsweise lediglich aus den Teilstrukturen T1c - gitterförmiger Bereich G1c und Knotenpunkte KNc - und der Teilstruktur T1b - gitterförmiger Bereich G1b und Knotenpunkte KNb -, so sind die Knotenpunkte KNb und KNc jeweils als Endpunkte einer Via-Verbindung V ausgebildet.

Es kann auch vorgesehen sein, dass die Kapazitätsstruktur K aus den beiden Teilstrukturen T1b und T1c - beide entsprechen in ihrer Ausbildung einer ersten Teilsstruktur - aufgebaut ist und die sich von den Knotenpunkten KNb in positiver z-Richtung nach oben erstreckenden Via-Verbindungen V einen Bereich des Halbleiterbauelements kontaktieren, der nicht mehr zur Kapazitätsstruktur K gehört.

Die nicht dargestellten Kapazitätsanteile C₁, C₂, und C₃ die zur Nutzkapazität der Kapazitätsstruktur K beitragen, werden im wesentlichen entsprechend wie in der Kapazitätsstruktur gemäß Fig. 1 erzeugt.

In Fig. 5 ist eine Draufsicht auf eine Teilstruktur wie sie beispielsweise in der Teilstruktur T1a ausgeführt ist, dargestellt. Der gitterförmige Bereich G1a weist quadratisch geformte Aussparungen auf, in denen jeweils eine viereckige metallische Platte P1a zentrisch angeordnet ist. Die Kapazitätsanteile C₁ bilden sich zwischen jeder der gegenüberliegenden Oberflächenbereiche aus.

In der Fig. 6 ist eine weitere Draufsicht auf eine Teilstruktur dargestellt. In diesem Beispiel ist ein gitterförmiger Bereich, beispielsweise G1a, derart ausgebildet, dass er kreisrunde Aussparungen aufweist, in denen jeweils eine runde metallische Platte, beispielsweise P1a, angeordnet ist.

In allen Ausführungsbeispielen ist die Teilstruktur T1c dem Halbleitersubstrat nächstgelegen.

Die Ausführungsbeispiele sind jeweils mit drei Metallisierungsebenen M1 bis M3 dargestellt und erläutert. Es kann auch vorgesehen sein, lediglich eine, zwei oder mehr als drei Metallisierungsebenen auszubilden in denen jeweils eine Teilstruktur ausgebildet ist, wobei in jeder Metallisierungsebene die gleiche Teilstruktur oder jeweils eine unterschiedliche Teilstrukturen ausgebildet ist.

## Patentansprüche

1. Halbleiterbauelement mit einem Halbleitersubstrat und einer auf dem Halbleitersubstrat ausgebildeten Isolationsschicht und einer in der Isolationsschicht ausgebildeten Kapazitätsstruktur (K), welche
- eine erste Teilstruktur (T1a) aufweist, welche einen zusammenhängenden gitterförmigen metallischen Bereich (G1a) aufweist, welcher sich derart in einer gemeinsamen Ebene (M1) parallel zur Substratoberfläche erstreckt, dass er gemeinsame obere und untere Oberflächen aufweist, die den gitterförmigen Bereich (G1a) in jedem seiner Teilbereiche von oben und von unten begrenzen, und der gitterförmige Bereich (G1a) mit einer ersten Anschlussleitung elektrisch verbunden ist, und
- welche elektrisch leitende Bereiche (P1a; KN) aufweist, die in den Aussparungen des gitterförmigen Bereichs (G1a) der ersten Teilstruktur (T1a) beabstandet zu den Randbereichen der Aussparungen in der Ebene (M1) angeordnet sind und die elektrisch leitenden Bereiche (P1a; KN) mit einer zweiten Anschlussleitung elektrisch verbunden sind,
**dadurch gekennzeichnet, dass**
die elektrisch leitenden Bereiche metallische Platten (P1a bis P1c) oder Knotenpunkte (KN) zwischen Via-Verbindungen sind.

2. Halbleiterbauelement nach Anspruch 1,
**dadurch gekennzeichnet, dass**
die Kapazitätsstruktur (K) eine zweite Teilstruktur (T1b) aufweist, die parallel und beabstandet zur ersten Teilstruktur (T1a) ausgebildet ist, und welche einen metallischen, zusammenhängenden gitterförmigen Bereich (G1b) aufweist, der sich derart in einer gemeinsamen Ebene (M2) parallel zur Substratoberfläche erstreckt, dass er gemeinsame obere und untere Oberflächen aufweist, die den gitterförmigen Bereich (G1b) in jedem seiner Teilbereiche von oben und unten begrenzen, wobei die erste und die zweite Teilstruktur (T1a, T1b) elektrisch verbunden sind.

3. Halbleiterbauelement nach Anspruch 2,
**dadurch gekennzeichnet, dass**
die zweite Teilstruktur (T1b) gleich der ersten Teilstruktur (T1a) aufgebaut ist und die beiden Teilstrukturen (T1a, T1b) so zueinander versetzt angeordnet sind, dass die elektrisch leitenden Bereiche (P1a) der ersten Teilstruktur (T1a) senkrecht über den Kreuzungspunkten (KP) des gitterförmigen Bereichs (G1b) der zweiten Teilstruktur (T1b) und die Kreuzungspunkte (KP) des gitterförmigen Bereichs (G1a) der ersten Teilstruktur (T1a) senkrecht über den elektrisch leitenden Bereichen (P1b) der zweiten Teilstruktur (T1b) angeordnet sind.

4. Halbleiterbauelement nach einem der Ansprüche 2 oder 3,
**dadurch gekennzeichnet, dass**
die Kreuzungspunkte (KP) des gitterförmigen Bereichs (G1a) der ersten Teilstruktur (T1a) mit den senkrecht darunter angeordneten, elektrisch leitenden Bereichen (P1b) der zweiten Teilstruktur (T1b) und die elektrisch leitenden Bereiche (P1a) der ersten Teilstruktur (T1a) mit den senkrecht darunter angeordneten Kreuzungspunkten (KP) des gitterförmigen Bereichs (G1b) der zweiten Teilstruktur (T1b) jeweils mittels mindestens einer Via-Verbindung (V) elektrisch verbunden sind.

5. Halbleiterbauelement nach Anspruch 2,
**dadurch gekennzeichnet, dass**
der gitterförmige Bereich (G1b) der zweiten Teilstruktur (T1b) zur ersten Teilstruktur (T1a) versetzt ist, so dass die elektrisch leitenden Bereich (P1a) der ersten Teilstruktur (T1a) senkrecht über den Kreuzungspunkten (KP) des gitterförmigen Bereichs (G1b) der zweiten Teilstruktur (T1b) angeordnet sind.

6. Halbleiterbauelement nach Anspruch 5,
**dadurch gekennzeichnet, dass**
die elektrisch leitenden Bereiche (P1a) der ersten Teilstruktur (T1a) und die Kreuzungspunkte (KP) des gitterförmigen Bereichs (G1b) der zweiten Teilstruktur (T1b) jeweils mittels einer oder mehrerer Via-Verbindungen (V) elektrisch verbunden sind.

7. Halbleiterbauelement nach einem der Ansprüche 2 bis 6,
**dadurch gekennzeichnet, dass**
eine weitere Teilstruktur als metallische Platte (MP) ausgebildet ist, die mit den Kreuzungspunkten (KP) eines gitterförmigen Bereichs (G1a; G1b) einer Teilstruktur (T1a, T1b) oder den elektrisch leitenden Bereichen (P1a, P1b) jeweils mittels einer oder mehrerer Via-Verbindungen (V) elektrisch verbunden ist.

8. Halbleiterbauelement nach einem der vorhergehenden Ansprüche,
**dadurch gekennzeichnet, dass**
die gitterförmigen Bereiche (G1a bis G1c) mindestens zwei eckig oder rund geformte Aussparungen aufweisen.

## Claims

1. Semiconductor component having a semiconductor substrate and having an insulating layer produced on the semiconductor substrate and having a capacitance structure (K) produced in the insulating layer, which
- has a first substructure (T1a) which has a cohesive latticed metal region (G1a) which extends in a common plane (M1) parallel to the substrate surface such that it has common top and bottom surfaces which limit the latticed region (G1a) in each of its subregions from above and from below, and the latticed region (G1a) is electrically connected to a first connecting line, and
- which first substructure has electrically conductive regions (P1a; KN) which are arranged in the cutouts in the latticed region (G1a) of the first substructure (T1a) at a distance from the edge regions of the cutouts in the plane (M1), and the electrically conductive regions (P1a; KN) are electrically connected to a second connecting line,
**characterized in that**
the electrically conductive regions are metal plates (P1a to P1c) or node points (KN) between via connections.

2. Semiconductor component according to claim 1,
**characterized in that**
the capacitance structure (K) has a second substructure (T1b) which is produced parallel to and at a distance from the first substructure (T1a) and which has a metal, cohesive latticed region (G1b) which extends in a common plane (M2) parallel to the substrate surface such that it has common top and bottom surfaces which limit the latticed region (G1b) in each of its subregions from above and below, the first and second substructures (T1a, T1b) being electrically connected.

3. Semiconductor component according to claim 2,
**characterized in that**
the second substructure (T1b) is of the same design as the first substructure (T1a), and the two substructures (T1a, T1b) are arranged offset from one another such that the electrically conductive regions (P1a) of the first substructure (T1a) are arranged vertically above the crossing points (KP) in the latticed region (G1b) of the second substructure (T1b), and the crossing points (KP) in the latticed region (G1a) of the first substructure (T1a) are arranged vertically above the electrically conductive regions (P1b) of the second substructure (T1b).

4. Semiconductor component according to either of claims 2 and 3,
**characterized in that**
the crossing points (KP) in the latticed region (G1a) of the first substructure (T1a) are electrically connected to the electrically conductive regions (P1b) of the second substructure (T1b) which are arranged vertically below, and the electrically conductive regions (P1a) of the first substructure (T1a) are electrically connected to the crossing points (KP) in the latticed region (G1b) of the second substructure (T1b) which are arranged vertically below, by means of at least one respective via connection (V).

5. Semiconductor component according to claim 2,
**characterized in that**
the latticed region (G1b) of the second substructure (T1b) is offset from the first substructure (T1a), so that the electrically conductive regions (P1a) of the first substructure (T1a) are arranged vertically above the crossing points (KP) in the latticed region (G1b) of the second substructure (T1b).

6. Semiconductor component according to claim 5,
**characterized in that**
the electrically conductive regions (P1a) of the first substructure (T1a) and the crossing points (KP) in the latticed region (G1b) of the second substructure (T1b) are electrically connected by means of one or more respective via connections (V).

7. Semiconductor component according to one of claims 2 to 6,
**characterized in that**
a further substructure is in the form of a metal plate (MP) which is electrically connected to the crossing points (KP) in a latticed region (G1a; G1b) of a substructure (T1a, T1b) or to the electrically conductive regions (P1a, P1b) by means of one of more respective via connections (V).

8. Semiconductor component according to one of the preceding claims,
**characterized in that**
the latticed regions (G1a to G1c) have at least two square or round cutouts.

## Revendications

1. Composant à semi-conducteur comprenant un substrat semi-conducteur et une couche isolante formée sur le substrat semi-conducteur et une structure (K) de capacité formée dans la couche isolante, qui
- a une première sous-structure (T1a) qui a une partie (G1a) métallique d'un seul tenant en forme de grille s'étendant dans un plan (M1) commun parallèlement à la surface du substrat, de sorte qu'elle a des surfaces communes supérieure et inférieure qui délimitent la partie (G1a) en forme de grille par le haut et par le bas dans chacune de ses sous-parties et la partie (G1a) en forme de grille est reliée électriquement à une première ligne de borne et
- qui a des parties (P1a ; KN) conductrices de l'électricité qui sont disposées dans les mailles de la partie (G1a) en forme de grille de la première sous-structure (T1a) dans le plan (M1) en étant à distance des parties de bord des mailles et les parties (P1a ; KN) conductrices de l'électricité sont reliées électriquement à une deuxième ligne de borne,
**caractérisé en ce que**
les parties conductrices de l'électricité sont des plaques (P1a à P1c) métalliques ou des points (KN) nodaux entre des liaisons par traversée.

2. Composant à semi-conducteur suivant la revendication 1,
**caractérisé en ce que**
la structure (K) de capacité a une deuxième sous-structure (T1b) qui est formée parallèlement et à distance de la première sous-structure (T1a) et qui a une partie (G1b) métallique d'un seul tenant en forme de grille s'étendant parallèlement dans un plan (M2) commun à la surface du substrat de façon à avoir des surfaces communes supérieure et inférieure qui délimitent par le haut et par le bas la partie (G1b) en forme de grille dans chacune de ses sous-parties, la première et la deuxième sous-structure (T1a, T1b) étant reliées électriquement.

3. Composant à semi-conducteur suivant la revendication 2,
**caractérisé en ce que**
la deuxième sous-structure (T1b) est constituée de la même façon que la première sous-structure (T1a) et les deux sous-structures (T1a, T1b) sont décalées l'une par rapport à l'autre, de manière à ce que les parties (P1a) conductrices de l'électricité de la première sous-structure (T1a) sont disposées perpendiculairement au-dessus des points (KP) d'intersection de la partie (G1b) en forme de grille de la deuxième sous-structure (T1b) et les points (KP) d'intersection de la partie (G1a) en forme de grille de la première sous-structure (T1a) sont disposés perpendiculairement au-dessus des parties (P1b) conductrices de l'électricité de la deuxième sous-structure (T1b).

4. Composant à semi-conducteur suivant l'une des revendications 2 ou 3,
**caractérisé en ce que**
les points (KP) d'intersection de la partie (G1a) en forme de grille de la première sous-structure (T1a) sont reliés électriquement aux parties (P1b) de la deuxième sous-structure (T1b) conductrices de l'électricité et disposés en dessous perpendiculairement et les parties (P1a) conductrices de l'électricité de la première sous-structure (T1a) sont reliées électriquement aux points (KP) d'intersection de la partie (G1b) en forme de grille de la deuxième sous-structure (T1b) disposés en dessous perpendiculairement respectivement au moyen d'au moins une liaison (V) par traversée.

5. Composant à semi-conducteur suivant la revendication 2,
**caractérisé en ce que**
la partie (G1b) en forme de grille de la deuxième sous-structure (T1b) est décalée par rapport à la première sous-structure (T1a) de façon à ce que la partie (P1a) conductrice de l'électricité de la première sous-structure (T1a) soit disposée perpendiculairement au-dessus des points (KP) d'intersection de la partie (G1b) en forme de grille de la deuxième sous-structure (T1b).

6. Composant à semi-conducteur suivant la revendication 5,
**caractérisé en ce que**
les parties (P1a) conductrices de l'électricité de la première sous-structure (T1a) et les points (KP) d'intersection de la partie (G1b) en forme de grille de la deuxième sous-structure (T1b) sont reliés électriquement respectivement au moyen d'une ou de plusieurs liaisons (V) par traversée.

7. Composant à semi-conducteur suivant l'une des revendications 2 à 6,
**caractérisé en ce**
**qu'**il est formé une autre sous-structure sous la forme d'une plaque (MP) métallique qui est reliée aux points (KP) d'intersection d'une partie (G1a ; G1b) en forme de grille d'une sous-structure (T1a, T1b) ou aux parties (P1a, P1b) conductrices de l'électricité, respectivement au moyen d'une ou de plusieurs liaisons (V) par traversée.

8. Composant à semi-conducteur suivant l'une des revendications précédentes,
**caractérisé en ce que**
les parties (G1a à G1c) en forme de grille ont au moins deux mailles de forme polygonale ou circulaire.
